# FASCICULE DE BREVET EUROPEEN

(11) **EP 0 597 785 B1**
(45) Date de publication et mention de la délivrance du brevet: **29.09.1999**
(21) Numéro de dépôt: 93440090.4
(22) Date de dépôt: 04.11.1993
(51) Int. Cl.: G01R 33/46

(54) **Procédé d'excitation et d'acquisition de signaux de résonance magnétique nucléaire, notamment dans l'eau légère**
Verfahren zur Anregung und Ermittlung von magnetischen Kernresonanzsignalen, insbesondere in Leichtwasser
Method for excitation and acquisition of nuclear magnetic resonance signals, particularly in light water

(30) Priorité: 13.11.1992 FR 9213825
(43) Date de publication de la demande: 18.05.1994
(60) Demande divisionnaire: 99102352.4
(73) Titulaire: BRUKER SA, 67160 Wissembourg (FR)
(72) Inventeur: Piotto, Martial, F-67160 Wissembourg (FR); Sklenar, Vladimir, 60200 Brno (CS); Saudek, Vladimir, F-67000 Strasbourg (FR)
(74) Mandataire: Nuss, Pierre

(56) Documents cités:
- EP-A- 0 370 333
- EP-A- 0 460 929
- EP-A- 0 467 467
- JOURNAL OF MAGNETIC RESONANCE. vol. 99, no. 3 , 1 Octobre 1992 , ORLANDO, MN US pages 638 - 643 A. BAX ET AL. 'OPTIMIZED RECORDING OF HETERONUCLEAR MULTIDIMENSIONAL NMR SPECTRA USING PULSED FIELD GRADIENTS'
- JOURNAL OF MAGNETIC RESONANCE. vol. 97, no. 2 , 1 Avril 1992 , ORLANDO, MN US pages 419 - 425 C.T.W. MOONEN ET AL. 'GRADIENT-ENHANCED EXCHANGE SPECTROSCOPY'
- JOURNAL OF MAGNETIC RESONANCE. vol. 97, no. 2 , 1 Avril 1992 , ORLANDO, MN US pages 305 - 312 J.-M. TYBURN ET AL. 'COHERENCE SELECTION IN GRADIENT-ENHANCED, HETERONUCLEAR CORRELATION SPECTROSCOPY'
- JOURNAL OF MAGNETIC RESONANCE. vol. 98, no. 1 , 1 Juin 1992 , ORLANDO, MN US pages 200 - 206 B.K. JOHN ET AL. 'EFFECTIVE COMBINATION OF GRADIENTS AND CRAFTED RF PULSES FOR WATER SUPPRESSION IN BIOLOGICAL SAMPLES'

## Description

La présente invention concerne le domaine des procédés et des techniques liés à l'application de la Résonance Magnétique Nucléaire (RMN), notamment pour des expériences de haute résolution, et a pour objet un procédé d'excitation et d'acquisition de signaux de RMN, notamment dans l'eau légère.

La RMN multidimensionnelle est devenue un instrument essentiel pour l'étude des molécules en solution, notamment des biomolécules, et a fait ses preuves en tant qu'alternative valable à la cristallographie par rayons X.

En effet, il est actuellement possible d'obtenir des structures de protéines jusqu'à 30-40 kD (kilo Dalton) en utilisant une combinaison d'expériences de RMN à deux dimensions, trois dimensions et quatre dimensions (voir notamment G. Marius Clore et Angela M. Gronenborn, "Progress in NMR Spectroscopy", 23, 43 - 1991).

Une étape cruciale pour la détermination de ces structures est l'attribution des signaux de tous les protons de la molécule à analyser et, en particulier, des protons en échange avec ceux de l'eau ou du solvant correspondant.

Puisque ces protons sont échangés avec l'eau, l'étude de ces molécules doit être réalisée dans une solution présentant une proportion d'au moins 90 % d'eau ou de solvant correspondant.

Dans ces conditions, la concentration en proton de l'eau est de 110 M (molaires) tandis que la concentration de soluté (molécules à analyser) est d'environ 2 mM (millimolaires).

Il en résulte des difficultés importantes pour l'observation de signaux qui sont environ 55 000 fois plus petits (plus faibles) que le signal le plus important, à savoir, celui correspondant aux protons de l'eau ou du solvant mis en oeuvre.

Un autre effet désavantageux de cette concentration importante de solvant est l'apparition d'un phénomène connu sous l'appellation "Radiation Damping" (atténuation de rayonnement), qui perturbe de manière supplémentaire l'observation des spins intéressants pour l'expérience.

En vue de tenter de résoudre ces problèmes, la solution la plus conventionnelle et la plus fréquemment utilisée est la présaturation de la résonance de l'eau.

Néanmoins, pour les protéines en pH neutre ou basique, cette solution conduit à une atténuation importante des résonances des protons amides et pour les acides nucléiques, à une disparition totale des signaux des protons imines et amides.

Cet inconvénient peut être évité en adoptant des séquences d'impulsions qui ne perturbent pas la population des spins de l'eau pendant le temps de relaxation.

Les différents procédés et méthodes de ce type connus actuellement peuvent être classés en trois catégories distinctes.

Une première catégorie de méthodes et de procédés met en oeuvre des séquences d'excitation sélective en tant qu'impulsion de détection du signal, tels que notamment le procédé connu sous la dénomination "jump and return", décrit par P. Plateau et M. Guéron dans le document J. Am. Chem. Soc., 104, 7310 (1982) ou encore le procédé connu sous la dénomination "11 - écho" décrit par V. Sklenar et A. Bax dans le document J. Magn. Reson., 74, 469 (1987).

Les différents procédés et méthodes regroupés dans la seconde catégorie proposent de déphaser la composante tranversale de l'aimantation de l'eau par un champ radiofréquence inhomogène au moyen d'un verrouillage de spins (voir B. A. Messerle, G. Wider, G. Wider, G. Otting, C. Weber et K. Wuthrich, J. Magn. Reson., 85, 608 - 1989).

Enfin, les procédés et méthodes de la troisième catégorie utilisent les technologies récentes développées dans le cadre des applications de gradients de champ pulsés (voir notamment G. W. Vuister, R. Boelens, R. Kaptein, R. E. Hurd, B. John, and P. C. M. Ziji, J. Am. Chem. Soc., 113, 9688 1991).

Néanmoins, ces trois catégories de procédés et méthodes connus mentionnés ci-dessus présentent de nombreux inconvénients communs, mais également spécifiques.

Leur inconvénient commun principal réside dans le fait que la suppression ou l'atténuation du signal du solvant, notamment de l'eau, est faible si un seul transitoire est enregistré et qu'une bonne atténuation du signal correspondant au solvant ou à l'eau ne peut être obtenue qu'après accomplissement d'un cycle de phase complet.

En outre, l'application de ces procédés et méthodes connus précités est limitée à certaines circonstances et conditions expérimentales.

Ainsi, le procédé "jump and return" peut être mis en oeuvre pour des expériences RMN à une dimension ou du type connu sous la dénomination NOESY (Nuclear Overhauser Effect Spectroscopy - spectroscopie à effet nucléaire Overhauser), mais est très peu performant en association avec des expériences RMN des types connus sous les dénominations TOCSY (TOtally Correlated Spectroscopy - spectroscopie totalement corrélée) et ROESY (ROtating Overhauser Effect Spectroscopy - spectroscopie à effet Overhauser dans le référentiel tournant) et n'est pratiquement pas mis en oeuvre pour des expériences RMN hétéronucléaires.

Le procédé mettant en oeuvre une impulsion de verrouillage de spins donne des résultats relativement bons pour des expériences RMN des types connus sous les dénominations HMQC (Heteronuclear Multiple Quantum Coherence - cohérence multiple quanta hétéronucléaire) et HSQC (Heteronuclear Single Quantum Coherence - cohérence simple quanta hétéronucléaire), mais est difficile à mettre en oeuvre pour des expériences homonucléaires.

Enfin, les procédés et méthodes mettant en oeuvre les techniques de gradients de champ pulsés ne sont efficaces, pour la suppression du pic de l'eau, que dans le cadre d'expériences RMN du type hétéronucléaire et ne sont d'aucune utilité dans le cadre des expériences de type NOESY, TOCSY et ROESY.

Par ailleurs l'utilisation de ces derniers procédés et méthodes entraîne une diminution de moitié du rapport signal/bruit.

Par le document EP-A-0 467 467, on connaît un procédé de spectroscopie RMN mettant en oeuvre une séquence d'impulsions destinée à atténuer le pic spectral correspondant à l'eau et utilisée systématiquement en combinaison avec une séquence expérimentale construite spécifiquement pour ne pas exciter l'eau.

Cette séquence d'impulsions d'atténuation du pic de l'eau consiste à appliquer un premier gradient de champ selon une direction donnée, à appliquer ensuite un champ radiofréquence sélectif de 180° n'affectant pas la fréquence de résonance de l'eau et enfin à appliquer un second gradient de champ identique au premier.

La présente invention a notamment pour but de pallier l'ensemble des inconvénients précités et de surmonter les limitations des procédés connus précités dans le domaine de la RMN haute résolution.

A cet effet, la présente invention a pour objet un procédé d'excitation et d'acquisition de signaux de RMN, notamment pour l'analyse de molécules dispersées dans un solvant tel que par exemple de l'eau, dans le cadre d'une expérience RMN haute résolution, présentant les caractéristiques mentionnées dans la revendication 1.

L'invention sera mieux comprise grâce à la description ci-après, qui se rapporte à des modes de réalisation préférés, donnés à titre d'exemple non limitatif, et expliqués avec référence aux dessins schématiques annexés, dans lesquels :
la figure 1A représente un diagramme schématique montrant le déroulement du procédé conforme à l'invention dans le cas général,
la figure 1B représente un diagramme schématique montrant le déroulement du procédé conforme à l'invention, selon un mode de réalisation particulier,
la figure 2 représente un diagramme spectral montrant le profil d'excitation générée par le champ radiofréquence pulsé sélectif de 180°, obtenu en appliquant le mode de réalisation particulier de l'invention représenté à la figure 1B,
la figure 3A représente un diagramme schématique montrant le déroulement du procédé selon l'invention mis en oeuvre dans le cadre d'une expérience de RMN du type 1D (à une dimension),
la figure 3B représente le spectre RMN recueilli après mise en oeuvre d'une expérience RMN du type représenté à la figure 3A,
les figures 4 à 7 représentent des diagrammes schématiques montrant le déroulement du procédé selon l'invention mis en oeuvre dans le cadre de différentes expériences de RMN, respectivement des types NOESY, TOCSY, ROESY et HSQC,
la figure 8A représente un diagramme schématique montrant le déroulement du procédé selon l'invention mis en oeuvre dans le cadre d'une expérience de RMN du type 1D (à une dimension), selon une variante de réalisation,
la figure 8B représente le spectre RMN recueilli après mise en oeuvre de l'expérience représentée à la figure 8A, effectuée dans les mêmes conditions que celles ayant conduit au spectre représenté à la figure 3B et,

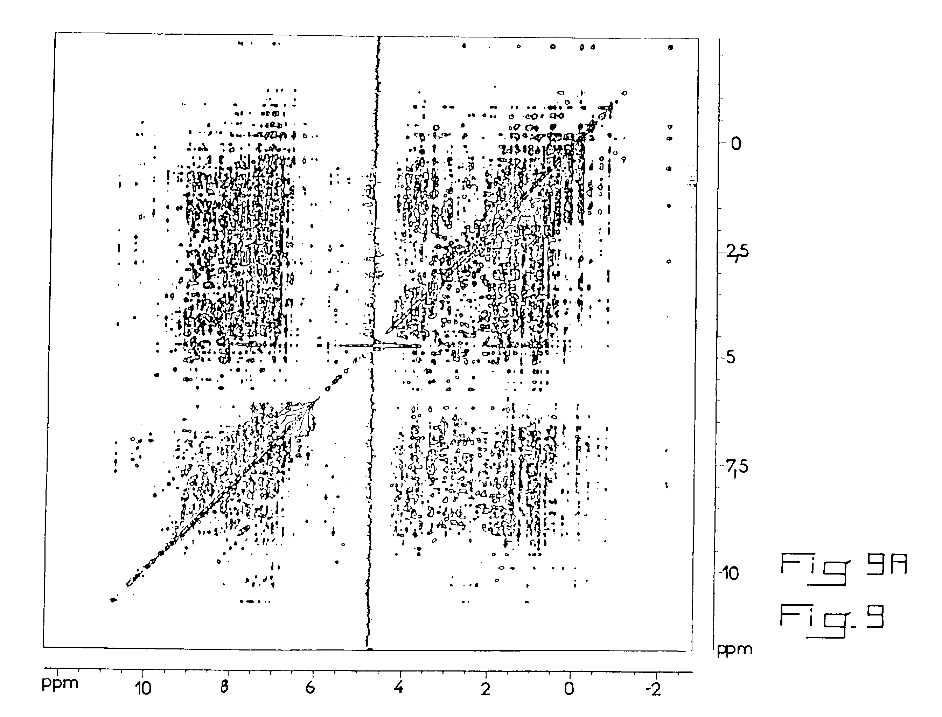

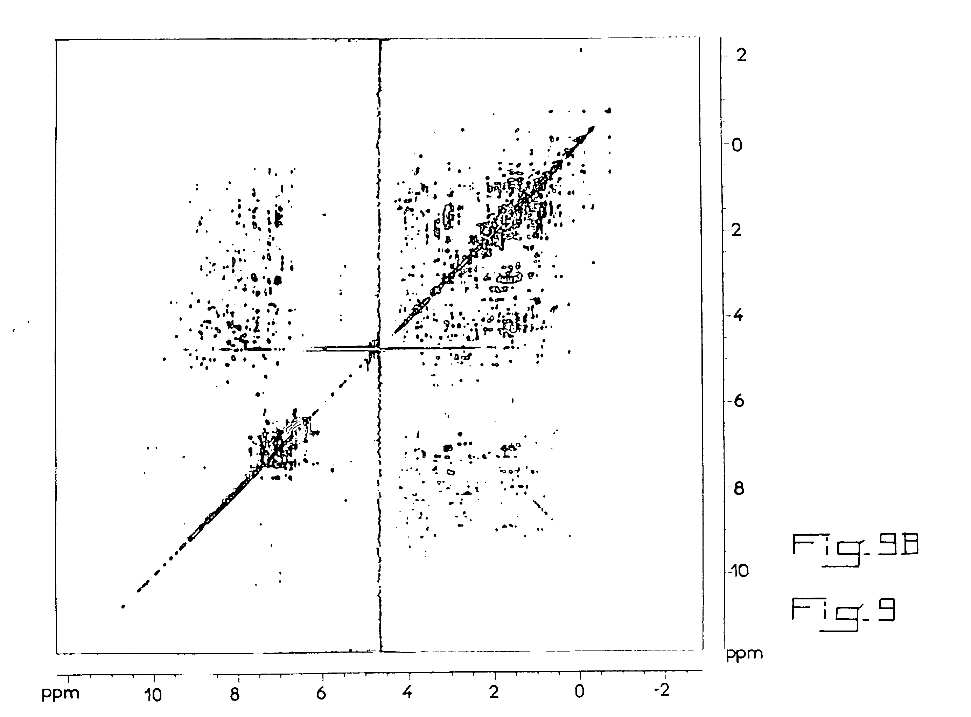

les figures 9A et 9B représentent les spectres RMN recueillis dans le cadre d'expériences de type NOESY et TOCSY, avec application du procédé selon l'invention.

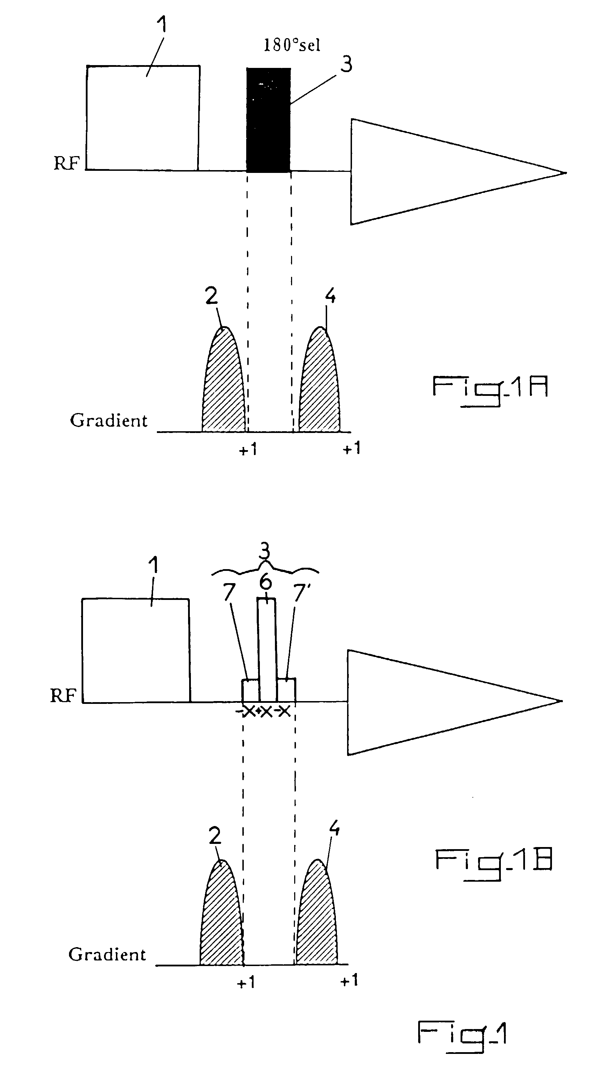

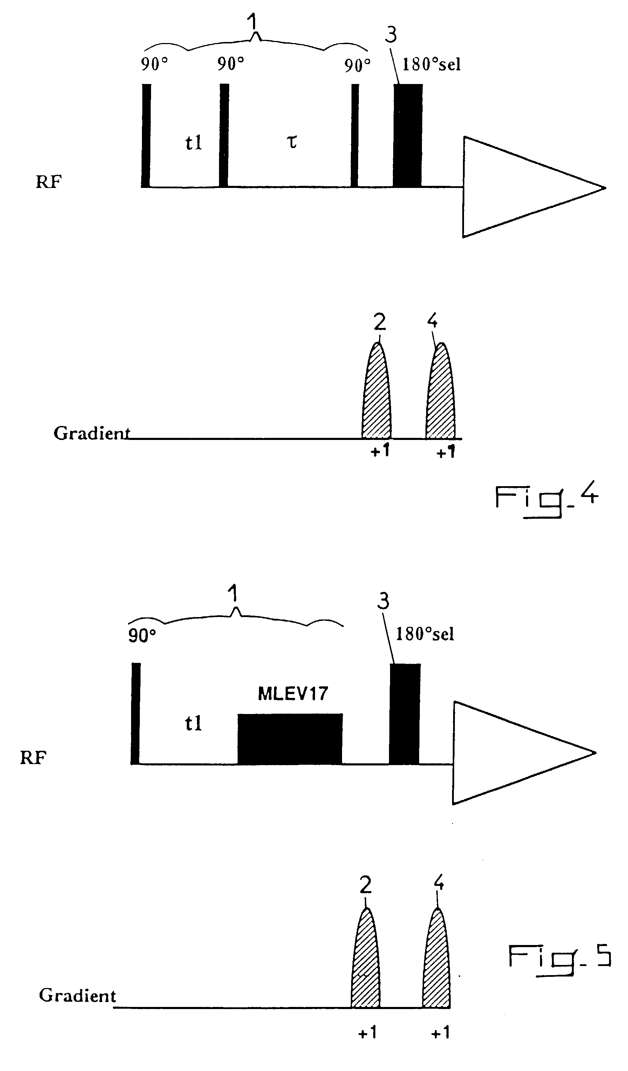

Conformément à l'invention, comme le montrent notamment les figures 1, 2, 3A, 4 à 7 et 8A des dessins annexés, le procédé d'excitation et d'acquisition de signaux de RMN consiste à soumettre tout d'abord l'échantillon à analyser à une séquence d'impulsions 1 correspondant à l'expérience de RMN haute résolution à réaliser, puis à lui appliquer un premier gradient de champ 2 pulsé selon une direction donnée, à le soumettre ensuite à un champ 3 radiofréquence pulsé sélectif de 180°, affectant tout le spectre à l'exception de la fréquence de résonance du solvant et constitué par trois composantes successives, à savoir, une impulsion radiofréquence 6 non sélective de 180° orientée selon une direction donnée X et deux impulsions radiofréquence sélectives de 90° 7 et 7' identiques, de faible puissance, dont l'une 7 précède et dont l'autre 7' suit l'impulsion radiofréquence 6 non sélective de 180°, en étant orientées selon une direction -X opposée à la direction X de cette dernière, à lui appliquer ensuite un second gradient de champ 4 pulsé, identique au premier 2 et, enfin, à effectuer l'acquisition et le traitement des signaux de RMN résultants.

Le champ radiofréquence 3 pulsé sélectif de 180° est par conséquent appliqué de manière sélective aux protons à analyser dans le cadre de l'expérience de RMN réalisée, mais n'affecte pas la résonance du solvant, par exemple préférentiellement de l'eau.

Ainsi, toutes les cohérences déphasées par le premier gradient de champ 2 pulsé sont rephasées par le second gradient de champ 4 pulsé, à condition qu'elles subissent une rotation de 180°, c'est-à-dire qu'elles soient affectées par le champ radiofréquence 3 pulsé sélectif de 180°.

Dans le présent mémoire, le terme "sélectif" désigne un champ ou une impulsion affectant l'ensemble du spectre, à l'exception de la fréquence de résonance de l'eau ou du solvant correspondant et le terme "non sélectif" désigne un champ ou une impulsion affectant tout le spectre sans exception.

Comme le montrent les figures 1, 3A, 4 à 7 et 8A des dessins annexés, les gradients de champ pulsés 2 et 4 et le champ radiofréquence 3 pulsé sélectif de 180° sont mis en oeuvre immédiatement après achèvement de la séquence d'impulsions correspondant à l'expérience de RMN à réaliser.

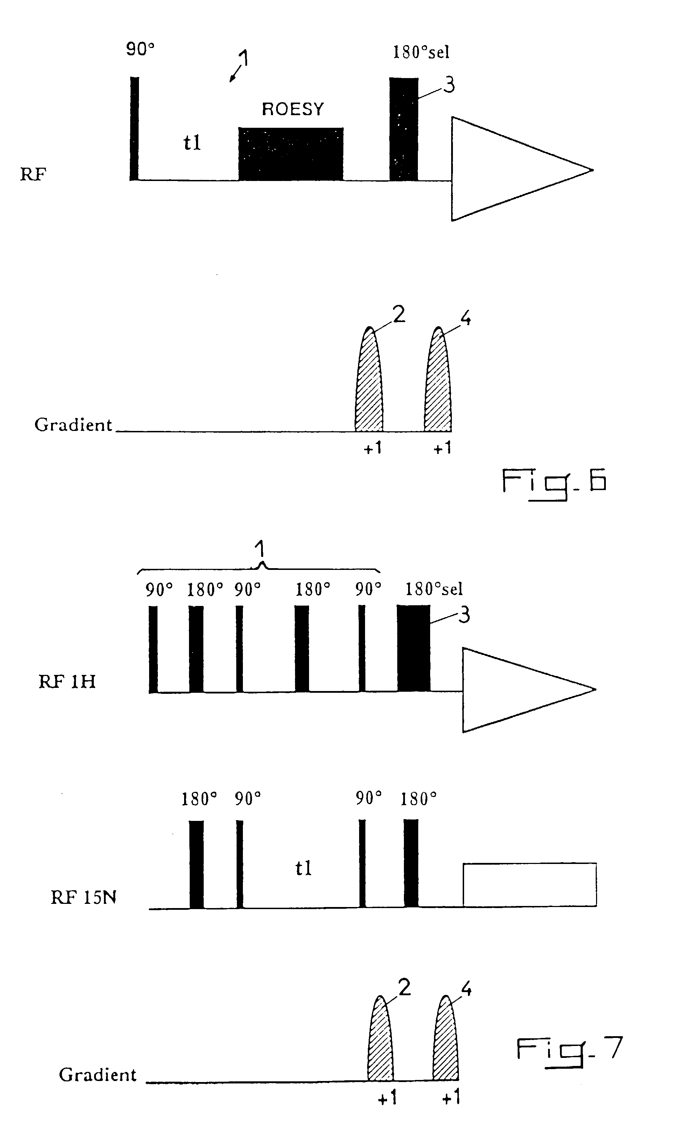

Pour le cas particulier d'une expérience du type HSQC, les gradients de champ 2 et 4 et l'application du champ radiofréquence 3 sont insérés dans la période de refocalisation de l'étape dite INEPT inversée (Insensitive Nuclei Enhanced by Polarisation Transfer - noyaux peu sensibles améliorés par transfert de polarisation). Il y a lieu, dans ce cas, de prendre en considération la durée des gradients de champ 2 et 4 et du champ radiofréquence 3 lors de l'ajustement du délai de refocalisation (figure 7).

Selon une première caractéristique de l'invention, représentée également sur les figures 1, 3A, 4 à 7 et 8A des dessins annexés, les deux gradients de champ 2 et 4 pulsés présentent préférentiellement des enveloppes d'impulsions de forme sinusoïdale, permettant de supprimer ou d'atténuer les signaux correspondant à l'eau ou au solvant utilisé, à un degré tel que leur intensité devient comparable à celle des signaux des protons à analyser dans le cadre de l'expérience réalisée.

Néanmoins, d'autres formes d'enveloppes sont également envisageables telles que par exemple des enveloppes du type carré, gaussien ou lorentzien.

La durée totale s'écoulant entre la fin de l'expérience de RMN réalisée et le début de l'acquisition des signaux de RMN résultants est inférieure à 6 millisecondes, ce en tenant compte des durées de recouvrement des gradients de 125 microsecondes environ.

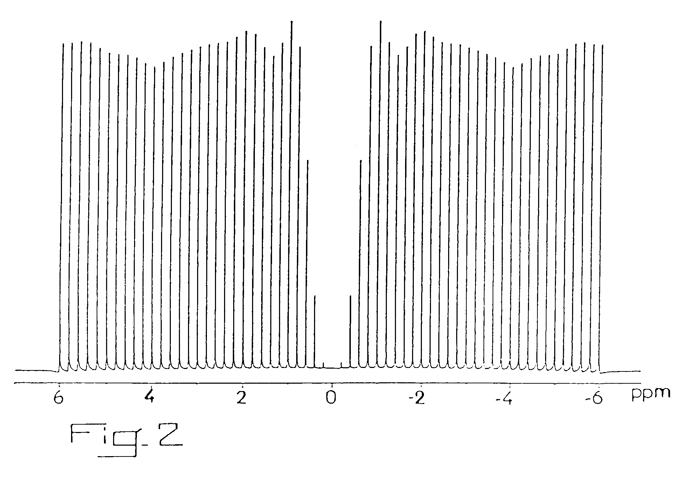

Les impulsions radiofréquence 7 et 7' sélectives de 90° peuvent consister, de manière avantageuse, soit en des impulsions rectangulaires, soit en des impulsions modulées en amplitude de manière telle que les variations d'amplitudes susceptibles d'être introduites dans le profil d'excitation soient éliminées (figure 2).

Pour le cas où des impulsions radiofréquence 7 et 7' rectangulaires sélectives de 90°, de faible puissance, sont mises en oeuvre, la largeur de la région non excitée est délimitée par la longueur desdites impulsions 7 et 7' sélectives de 90° (longueur T) tandis que la largeur de bande d'excitation est limitée principalement par l'intensité du champ radiofréquence de l'impulsion 6 non sélective de 180°.

Selon une première approximation, le domaine spectral présentant des intensités réduites est limité aux fréquences multiples de 1/T à partir de la fréquence de la porteuse centrée sur la position spectrale correspondant au pic de résonance de l'eau.

La variation d'amplitude introduite par les deux impulsions rectangulaires 7 et 7' sélectives de 90° est inférieure à 10 % et peut être supprimée en modulant les enveloppes de ces impulsions 7 et 7' .

La séquence d'impulsions décrite ci-dessus génère des spectres composés de signaux de phase pure et réalise une suppression ou une atténuation importante du pic correspondant à l'eau ou au solvant correspondant, avec un facteur d'atténuation de l'ordre de 10⁴ à 10⁵, ce lors d'un unique balayage.

Cette propriété avantageuse de l'invention provient du fait que, dans le cadre d'un balayage unique, l'effet des deux gradients de champ pulsés 2 et 4 précédant et suivant l'impulsion radiofréquence 3 sélective de 180° est, pour l'essentiel, équivalent à l'application d'un procédé de cycle de phase à quatre étapes connu sous la dénomination EXORCYCLE et décrit dans le document "Journal of Magnetic Resonance", 27, 511-514, 1977 par Geoffrey Bodenhausen, Ray Freeman et David L. Turner.

Le gradient de champ pulsé 4 précédant immédiatement la phase d'acquisition assure une élimination pratiquement complète du pic spectral correspondant à l'eau ou au solvant utilisé et autorise l'emploi de gains du récepteur très élevés.

En outre, et contrairement aux différents procédés et méthodes connus de l'art antérieur, le procédé d'excitation et d'acquisition conforme à l'invention, peut être utilisé en association avec la plupart des expériences RMN haute résolution, notamment celles mentionnées au début du présent mémoire.

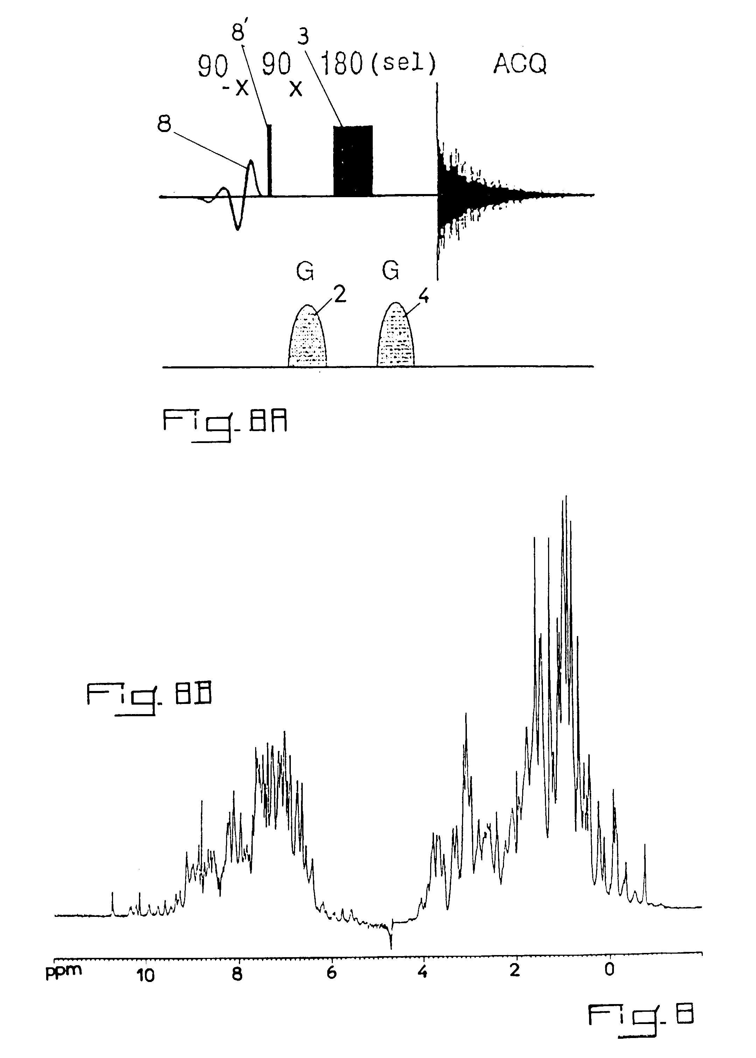

Conformément à une variante de réalisation de l'invention, représentée à la figure 8A des dessins annexés, le procédé d'excitation et d'acquisition consiste, de manière avantageuse, avant émission de la séquence d'impulsions 1 correspondant à l'expérience de RMN haute résolution à réaliser, à soumettre l'échantillon à une impulsion de radiofréquence 8 sélective de 90°, présentant une fréquence de porteuse identique à la fréquence de résonance du solvant, par exemple de l'eau, de telle manière que l'aimantation du solvant retourne à sa position d'équilibre sous l'influence d'une seconde impulsion radiofréquence 8' non sélective de 90°.

La Figure 8a représente la mise en oeuvre de cette disposition supplémentaire de l'invention dans le cadre d'une expérience RMN 1D. Néanmoins, il est également possible d'appliquer cette disposition en association avec d'autres expériences RMN, notamment du type 2D.

Cette disposition supplémentaire de l'invention permet, lorsque le délai de relaxation est sensiblement de même valeur que le temps de relaxation T1 de l'eau ou du solvant correspondant, d'éviter une saturation partielle de la résonance de l'eau ou du solvant correspondant, et donc une saturation et une modification des signaux des protons échangés avec l'eau ou le solvant, ces effets néfastes pouvant éventuellement également être transférés, par l'intermédiaire de la diffusion des spins aux protons non échangés avec l'eau ou le solvant correspondant.

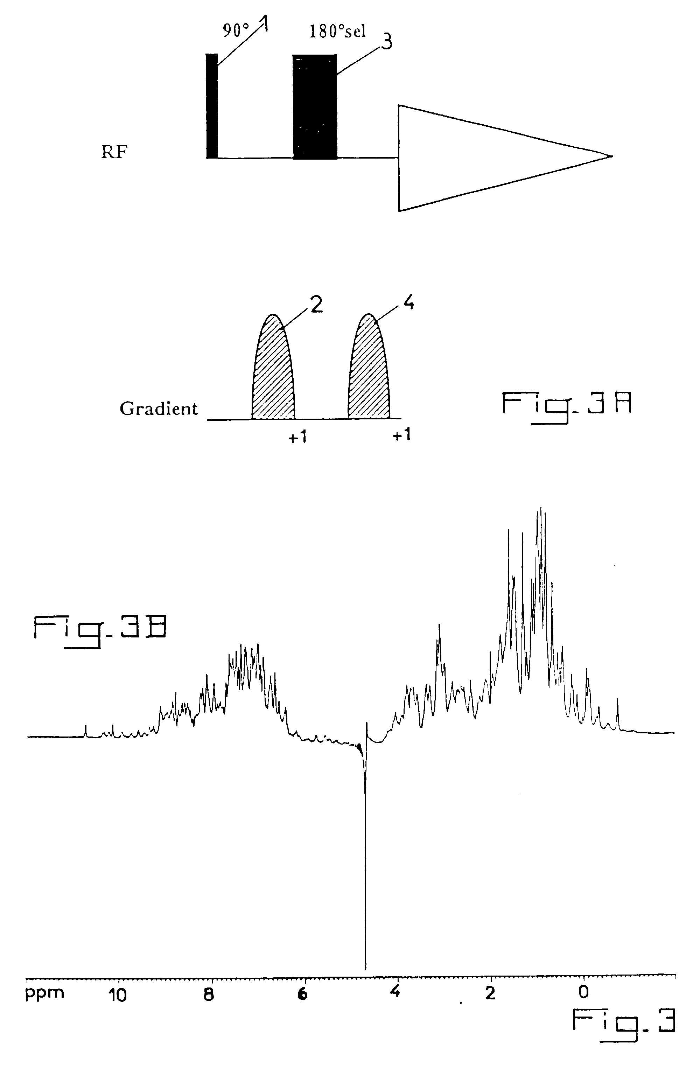

L'effet bénéfique de cette disposition supplémentaire de l'invention peut être aisément constaté en comparant les spectres RMN représentés sur les figures 3B et 8B.

L'impulsion 8 sélective de 90° appliquée peut, par exemple, consister en une impulsion du type connu sous la dénomination EBURP 2 (Excitation Band selective Uniform Response Pure phase - excitation uniforme sélective de phase pure) et décrite notamment dans "Journal of magnetic resonance", 93, 93-141, 1991 par Helen Geen and Ray Freeman. Une telle impulsion 8, permet de réaliser une excitation à bande étroite des molécules d'eau ou de solvant correspondant, avec une phase uniforme sur la largeur de bande d'excitation et une perturbation négligeable dans les autres domaines spectraux restants.

Le procédé d'excitation et d'acquisition selon la présente invention décrit ci-dessus en association avec des expériences RMN à une dimension ou à deux dimensions peut, bien évidemment, également être mis en oeuvre en association ou dans le cadre d'expériences de RMN tridimentionnelles ou quadridimentionnelles.

Bien entendu, l'invention n'est pas limitée aux modes de réalisation décrits et représentés aux dessins annexés. Des modifications restent possibles sans sortir pour autant du domaine de protection de l'invention.

## Revendications

1. Procédé d'excitation et d'acquisition de signaux de RMN, notamment pour l'analyse de molécules dispersées dans un solvant, tel que par exemple de l'eau, dans le cadre d'une expérience RMN haute résolution, consistant à soumettre tout d'abord l'échantillon à analyser à une séquence d'impulsions (1) correspondant à l'expérience de RMN haute résolution à réaliser, puis à lui appliquer un premier gradient de champ (2) pulsé selon une direction donnée, à le soumettre ensuite à un champ radiofréquence pulsé sélectif de 180° (3), affectant tout le spectre à l'exception de la fréquence de résonance du solvant et constitué par trois composantes successives, à savoir, une impulsion radiofréquence non sélective de 180° (6) orientée selon une direction donnée (X) et deux impulsions radiofréquence sélectives de 90° (7 et 7') identiques, de faible puissance, dont l'une (7) précède et dont l'autre (7') suit l'impulsion radiofréquence non sélective de 180° (6), en étant orientées selon une direction (-X) opposée à la direction (X) de cette dernière, à lui appliquer ensuite un second gradient de champ (4) pulsé, identique au premier (2) et, enfin, à effectuer l'acquisition et le traitement des signaux de RMN résultants.

2. Procédé, selon la revendication 1, caractérisé en ce que les deux gradients de champ (2 et 4) pulsés présentent des enveloppes d'impulsions de forme sinusoïdale.

3. Procédé, selon la revendication 1, caractérisé en ce que les impulsions radiofréquence sélectives d 90° (7 et 7') consistent, soit en des impulsions rectangu laires, soit en des impulsions modulées en amplitude de manière déterminée.

4. Procédé, selon l'une quelconque des revendications 1 à 3, caractérisé en ce qu'il consiste, avant émission de la séquence d'impulsions (1) correspondant à l'expérience de RMN haute résolution à réaliser, à soumettre l'échantillon à une impulsion de radiofréquence sélective de 90° (8), à la fréquence de résonance du solvant, de telle manière que l'aimantation du solvant retourne à sa position d'équilibre sous l'influence d'une seconde impulsion radiofréquence (8') non sélective de 90°.

5. Procédé, selon la revendication 4, caractérisé en ce que le champ radiofréquence pulsé sélectif de 90° (8) appliqué consiste en une impulsion du type connu sous la dénomination EBURP 2.

## Patentansprüche

1. Verfahren zur Anregung und Aufnahme von Kernresonanzsignalen, insbesondere für die Analyse von in einem Lösungsmittel, wie zum Beispiel Wasser, dispergierten Molekülen, im Rahmen eines Experiments mit magnetischer Kernresonanz mit hoher Auflösung, das darin besteht, zuerst die zu analysierende Probe einer Sequenz von Impulsen (1) zu unterziehen, die dem herzustellenden Experiment mit magnetischer Kernresonanz mit hoher Auflösung entspricht, dann einen ersten impulsförmigen Feldgradienten (2) in einer vorgegebenen Richtung darauf anzuwenden, sie dann einem selektiven impulsförmigen 180°-Hochfrequenzfeld (3) zu unterziehen, das das gesamte Spektrum mit Ausnahme der Resonanzfrequenz des Lösungsmittels beeinflußt und aus arei aufeinanderfolgenden Komponenten gebildet wird, nämlich einem nicht-selektiven 180°-Hochfrequenzimpuls (6), der in einer vorgegebenen Richtung (X) gerichtet ist, und zwei identischen selektiven 90°-Hochfrequenz-Impulsen (7 und 7'), mit geringer Leistung, wobei einer (7) dem nicht-selektiven 180°-Hochfrequenzimpuls (6) vorausgeht und der andere (7') diesem folgt, wobei sie in einer Richtung (-X) gerichtet sind, die der Richtung (X) von letzterem entgegengesetzt ist, dann einen zweiten impulsförmigen Feldgradienten (4) auf diese anzuwenden, der mit dem ersten (2) identisch ist, und schließlich die Aufnahme und Behandlung der resultierenden Kernresonanzsignale durchzuführen.

2. Verfahren nach Anspruch 1, dadurch gekennzeichnet, daß die beiden impulsförmigen Feldgradienten (2 und 4) sinusförmige Impulseinhüllende aufweisen.

3. Verfahren nach Anspruch 1, dadurch gekennzeichnet, daß die selektiven 90°-Hochfrequenzimpulse (7 und 7') entweder aus rechtwinkligen Impulsen oder aus in bestimmter Weise amplitudenmodulierten Impulsen bestehen.

4. Verfahren nach einem der Ansprüche 1 bis 3, dadurch gekennzeichnet, daß es darin besteht, vor der Emission der Impulssequenz (1), die dem herzustellenden Experiment mit magnetischer Kernresonanz mit hoher Auflösung entspricht, die Probe einem selektiven 90°-Hochfrequenzimpuls (8), bei der Resonanzfrequenz des Lösungsmittels, zu unterziehen, derart, daß die Magnetisierung des Lösungsmittels unter dem Einfluß eines zweiten nicht-selektiven 90°-Hochfrequenzimpulses (8') in seine Gleichgewichtsstellung zurückgeht.

5. Verfahren nach Anspruch 4, dadurch gekennzeichnet, daß das angewandte impulsförmige selektive 90°-Hochfrequenzfeld aus einem Impuls der unter der Bezeichnung EBURP 2 bekannten Art besteht.

## Claims

1. Method for excitation and acquisition of NMR signals, in particular for the analysis of molecules dispersed in a solvent such as, for example, water, in the context of a high-resolution NMR experiment, which involves firstly subjecting the samples to be analysed to a sequence of pulses (1) corresponding to the high-resolution NMR experiment to be carried out, then applying to it a first pulsed field gradient (2) in a given direction, subsequently subjecting it to a selective pulsed radiofrequency field of 180° (3) affecting the entire spectrum apart from the resonant frequency of the solvent and consisting of three successive components, that is a non-selective radiofrequency pulse of 180° (6) orientated in a given direction (X) and two identical selective radiofrequency pulses of 90° (7 and 7') of low power of which one (7) precedes and the other (7') follows the non-selective radiofrequency pulse of 180° (6) while being orientated in a direction (-X) opposed to the direction (X) thereof, subsequently applying to it a second pulsed field gradient (4) identical to the first two and, finally, acquiring and processing the resultant NMR signals.

2. Method according to claim 1, characterised in that the two pulsed field gradients (2 and 4) have sinusoidal pulse envelopes.

3. Method according to claim 1, characterised in that the selective radiofrequency pulses of 90° (7 and 7') consist either of rectangular pulses or of pulses which are amplitude modulated in a predetermined manner.

4. Method according to any one of claims 1 to 3, characterised in that it involves, before emission of the sequence of pulses (1) corresponding to the high-resolution NMR experiment to be carried out, subjecting the sample to a selective radiofrequency pulse of 90° (8) at the resonant frequency of the solvent such that the magnetisation of the solvent returns to its equilibrium position under the influence of a second non-selective radiofrequency pulse (8') of 90°.

5. Method according to claim 4, characterised in that the selective pulsed radiofrequency field of 90° (8) applied consists of a pulse of the type known by the name EBURP 2.
